(19) Europäisches Patentamt
European Patent Office
Office européen des brevets

(11) **EP 2 538 420 A1**

(12) **EUROPÄISCHE PATENTANMELDUNG**

(43) Veröffentlichungstag:
**26.12.2012 Patentblatt 2012/52**

(51) Int Cl.:
*H01G 4/12* *(2006.01)*    *H01G 7/06* *(2006.01)*
*H01L 21/02* *(2006.01)*

(21) Anmeldenummer: **11170576.0**

(22) Anmeldetag: **20.06.2011**

(84) Benannte Vertragsstaaten:
**AL AT BE BG CH CY CZ DE DK EE ES FI FR GB
GR HR HU IE IS IT LI LT LU LV MC MK MT NL NO
PL PT RO RS SE SI SK SM TR**
Benannte Erstreckungsstaaten:
**BA ME**

(71) Anmelder: **Technische Universität Darmstadt
64283 Darmstadt (DE)**

(72) Erfinder:
• **Jakoby, Rolf
61191 Rosbach (DE)**

• **Klein, Andreas
64285 Darmstadt (DE)**
• **Schafranek, Robert
64285 Darmstadt (DE)**
• **Li, Shunyi
64287 Darmstadt (DE)**
• **Zheng, Yuliang
64347 Griesheim (DE)**

(74) Vertreter: **Stumpf, Peter
c/o TransMIT GmbH
Kerkrader Strasse 3
35394 Gießen (DE)**

(54) **Kondensator für passive Hochfrequenz-Komponenten**

(57) Die Erfindung betrifft einen programmierbaren, nicht-flüchtigen, bi-stabilen Kondensator für den Hochfrequenzbereich. Der Kondensator kann als Varaktor (abstimmbarer Kondensator) oder als Speicherelement verwendet werden, insbesondere in HF-Kommunikationssystemen beispielsweise als steuerbare Mikrowellenkomponenten und als HF-Speicher beispielsweise in Radio Frequency Identification (RFID) Tags zur Speicherung der ID-Nummer oder zur Speicherung der Betriebsfrequenz in Oszillatoren. Der Kondensator weist mindestens eine Schicht mit einem Material mit einer hohen abstimmbaren relativen Permittivität (abstimmbare Schicht 11) kombiniert mit mindestens einer Schicht eines Materials mit einer großen Energiebandlücke (Barriereschicht 12) und mindestens zwei Elektroden (10, 13) auf.

Fig. 2

EP 2 538 420 A1

**Beschreibung**

Die Erfindung betrifft einen programmierbaren, nicht-flüchtigen, bi-stabilen Kondensator für den Hochfrequenzbereich. Der Kondensator kann als Varaktor (abstimmbarer Kondensator) oder als Speicherelement verwendet werden, insbesondere in HF-Kommunikationssystemen beispielsweise als steuerbare Mikrowellenkomponenten und als HF-Speicher beispielsweise in Radio Frequency Identification (RFID) Tags zur Speicherung der ID-Nummer oder zur Speicherung der Betriebsfrequenz in Oszillatoren. Der Kondensator weist mindestens eine Schicht mit einem Material mit einer hohen abstimmbaren relativen Permittivität (abstimmbare Schicht 11) kombiniert mit mindestens einer Schicht eines Materials mit einer großen Energiebandlücke (Barriereschicht 12) und mindestens zwei Elektroden (10, 13) auf.

**Beschreibung**

**Stand der Technik**

Die Entwicklung moderner Halbleitertechnologien erhöht kontinuierlich die Anforderungen an Materialien, Systeme und Prozesstechniken. Beispiele sind dies immer höhere Integrierbarkeit und Multifunktionalität für Kommunikationssysteme, und eine höhere Dichte und Stabilität für dynamische Speicher.
Im Stand der Technik sind verschiedene Arten von Varaktoren und Speicherelementen bekannt, die als Festkörperschaltkreise ausgeführt sind:

Beim Betrieb in Sperrrichtung variiert eine Diode die Dicke der Verarmungszone entsprechend der angelegten Spannung. Da die Kapazität umgekehrt proportional zur Dicke der Verarmungszone ist wird diese durch die angelegte Spannung gesteuert. Dioden weisen keine Funktion der Informationsspeicherung auf. In Speichersystemen mit Dioden sind alle nicht-flüchtigen Speicherfunktionen durch externe Schaltungen realisiert, welche die spezifischen Betriebsspannungen als vorgegebene Werte von zusätzlichen Speichern oder durch Echtzeit-Berechnung ermitteln.

(Ba,Sr)TiO$_3$ (BST)-Dünnschichtkondensatoren für Anwendungen in der Hochfrequenztechnik besitzen in der Regel eine MIM-Struktur (Metall/Isolator/Metall), die als zwei entgegengesetzt geschaltete Schottky-Dioden betrachtet werden können. Eine relativ kleine Barrierenhöhe verursacht eine erhöhte Elektronen-Injektion. Der resultierende Leckstrom führt zu hohen dielektrischen Verlusten und kurzen Lebensdauern.

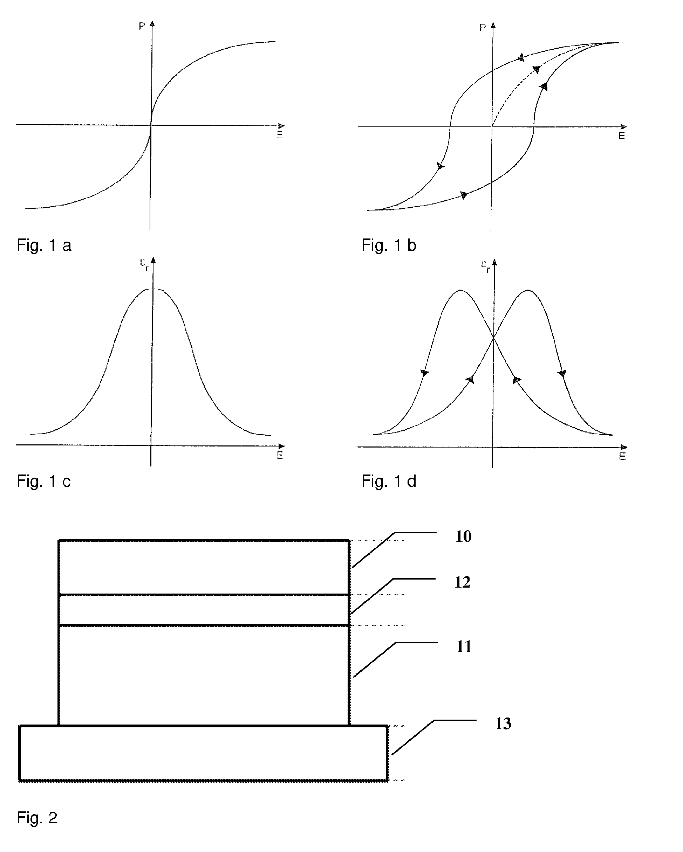

Die Kapazitäten von Varaktoren (abstimmbaren Kondensatoren) bestehend aus paraelektrischen Materialien können durch externe elektrische Felder aktiv abgestimmt werden. Grundlage hierfür ist die (nichtlineare) Abhängigkeit der induzierten Polarisation des paraelektrischen Materials von elektrischen Feldern. Die relative Permittivität (Dielektrizitätskonstante) $\varepsilon_r$ solcher Materialien, die die Ableitung der Polarisation P in Bezug auf die elektrische Feldstärke E ist, zeigt symmetrische Eigenschaften und sinkt, wenn das angelegte elektrische Feld erhöht wird, wie in Fig. 1 a und Fig.1 c dargestellt. Beim Betrieb über ihrer Curie-Temperatur, im paraelektrischen Bereich des Materials, ist die verbleibende Hysterese vernachlässigbar. Diese Varaktoren benötigen externe Bauelemente um den jeweiligen Betriebspunkt zu speichern.
Eine weitere Möglichkeit besteht darin ferroelektrische Materialien anstelle des paraelektrischen Materials bei Betriebstemperaturen zu verwenden, bei denen die elektrischen Dipole spontane Polarisationen bilden. Durch Anlegen eines externen elektrischen Feldes, richtet sich die Polarisation der Dipole tendenziell entsprechend dem elektrischen Feld aus und behält diese Ausrichtung zum Teil bei auch nach Abschalten des elektrischen Feldes. Dadurch ist eine kapazitive Hysterese vorhanden, wie in Fig. 1 b und Fig. 1 d dargestellt. Durch die Erfassung der tatsächlichen Kapazität, wird der programmierte Wert aus der Polarisation ausgelesen ohne zusätzliche Schaltungselemente.
Unter den verschiedenen Speichertechnologien bekamen ferroelektrische Speicher, unter anderem FeRAM (engl. ferroelectric random access memory), in der letzten Zeit eine besondere Beachtung als einer der zukünftigen nicht-flüchtigen Speicher, da FeRAMs, im Vergleich mit anderen konventionellen nicht-flüchtigen Technologien, schneller, robuster und kompakter sind. Die ferroelektrischen Speicher basieren auf der spontanen Polarisation ferroelektrischer Dünnschichten, die phänomenologisch als eine Hysterese in der CV (capacitance-voltage)- sowie PV (polarisation-voltage)-Kennlinie erscheint. Durch die Hysterese können zwei unterscheidbare logische Zustände anhand der Richtung der Polarisation und der darauffolgenden Schaltladung definiert werden, welche als die grundlegende Voraussetzung für die Anwendung als Speichervorrichtung dient.
Einer der Nachteile von ferroelektrischen Speichern ist die relativ aufwändige Schaltungsstruktur, die eine Kombination von einem oder mehreren Transistoren und Kondensatoren umfasst. Die gespeicherte Information, das heißt, die Ladung der Polarisation, wird durch die Lesespannung gelöscht und muss nach dem Lesevorgang erneuert werden. Außerdem weisen die Materialien in der ferroelektrischen Phase einen höheren dielektrischen Verlust auf, besonders bei hohen Frequenzen, verursacht durch die Umpolung der Polarisation und der Bewegung der ferroelektrischen Domänen. Diese Eigenschaft verhindert den Einsatz der Materialien in der ferroelektrischen Phase als Mikrowellenkomponente.

Keine dieser Möglichkeiten im Stand der Technik erlaubt eine Anwendung und Programmierbarkeit im Hochfrequenz-Bereich. Geringe Verluste sind eine wesentliche Voraussetzung für Hochfrequenz-Kondensatoren. Beim Betrieb nahe oder unterhalb der Curie-Temperatur, zeigen ferroelektrischen Materialien stark frequenzabhängige Eigenschaften im Mikrowellenbereich. Für typische ferroelektrische Materialien wie Pb (ZrTi) $O_3$, reduziert sich die Permittivität um 50% zwischen 300 MHz und 3 GHz, während die dielektrischen Verluste um mehr als das 1,5-fache zunehmen. Dies führt zu hohen Verlusten im Mikrowellenbereich. Die fehlende eigene Speicher-Funktion in Dioden oder in Varaktoren, die auf paraelektrischen Materialien basieren, führen zu peripherer Komplexität. Zusätzlich weisen Dioden bei Betrieb im Sperrbereich hohe Verluste auf. Dies erhöht den Stromverbrauch und ist der limitierende Faktor in semipassiven Komponenten, z.B. Backscatter RFID.

**Aufgabe**

Es ist Aufgabe der Erfindung einen passiven, abstimmbaren, programmierbaren, nicht-flüchtigen und bistabilen Kondensator für die Hochfrequenztechnik zur Anwendung als Varaktor oder als Speicherelement zur Verfügung zu stellen.

**Lösung der Aufgabe**

Die Erfindung betrifft einen programmierbaren, nicht-flüchtigen, bi-stabilen Kondensator für den Hochfrequenzbereich nach Anspruch 1. Der Kondensator kann als Varaktor (abstimmbarer Kondensator) oder als Speicherelement verwendet werden, insbesondere in HF-Kommunikationssystemen beispielsweise als steuerbare Mikrowellenkomponenten und HF-Speichern beispielsweise als Radio Frequency Identification (RFID) Tags zur Speicherung der ID-Nummer oder zur Speicherung der Betriebsfrequenz in Oszillatoren. Der Kondensator weist mindestens eine Schicht mit einem Material mit einer hohen abstimmbaren relativen Permittivität (abstimmbare Schicht 11) kombiniert mit mindestens einer Schicht eines Materials mit einer großen Energiebandlücke (Barriereschicht 12, 14) und mindestens zwei Elektroden (10, 13) auf.

Bi-Stabilität bedeutet, dass der Kondensator zwei logische Zustände aufweist, die nach der Entfernung der zuvor angelegten elektrischen Spannung verbleiben (d.h. sie sind nicht-flüchtig), und anschließend durch Anlegen einer Spannung umgeschaltet werden können (d.h. sie sind programmierbar).

Die abstimmbare Schicht 11 weist ein Material mit einer nicht-linearen relativen Permittivität auf, besonders bevorzugt eines der folgenden Materialien oder eine Kombination aus den folgenden Materialien: BaTiO$_3$, SrTiO, (Ba, Sr)TiO$_3$, (Ba,Ca)TiO$_3$, Ba(Ti,Zr)O$_3$, Ba(Ti,Sn)O$_3$ und weiteren Materialien mit nicht linearer relativer Permittivität.

Die Barriereschicht 12, 14 weist bevorzugt eines der folgenden Materialien auf SiO$_2$, Si$_3$N$_4$, Al$_2$O$_3$, ZrO$_2$, ZrSiO$_4$, HfO$_2$, HfSiO$_4$, La$_2$O$_3$, Y$_2$O$_3$, MgO, CaO, SrO.

Der besonders bevorzugte Frequenzbereich für die Anwendung des erfindungsgemäßen Kondensators für den Hochfrequenzbereich startet bei unter 1 MHz und geht bis über 10 GHz.

Diese Erfindung kombiniert die Funktionen der paraelektrischen und ferroelektrischen Materialien und hat den Vorteil, dass die Verluste im Hochfrequenz-Bereich minimal gehalten werden können, wobei sich die Kapazität deutlich verändert entsprechend der unterschiedlichen Programmierungen. Weiterhin reduziert die hochohmige Barriereschicht 12, 14 den Leckstrom auf 0,1%. Dies ermöglicht Schaltungen mit sehr geringem Stromverbrauch.

Die Kombination von Materialien mit niedriger Permittivität wie z.B. Al$_2$O$_3$ und hoher Permittivität wie z.B. (Ba, Sr)TiO$_3$ ermöglicht das Speichern von Ladungen an der BST/Al$_2$O$_3$-Grenzfläche und kann eine "künstliche" Hysterese im paraelektrischen Material erzeugen, die sonst nur in ferroelektrischen Materialien zu sehen ist. Das Hystereseverhalten ist nicht mit einer Ferroelektrizität verknüpft, bietet aber eine ähnliche Bistabilität. Außerdem weisen die Kondensatoren, die auf paraelektrischem Material wie z.B. (Ba,Sr)TiO$_3$ basieren, eine einfache Schaltungsstruktur sowie niedrige dielektrische Verluste auf, womit sie sich für die Anwendung als Mikrowellenkomponente eignen. Das bedeutet, dass durch diese Methode ein neues Element - ein bistabiler Kondensator - realisiert werden kann, der gleichzeitig Mikrowelleneigenschaften und Speichereigenschaften besitzt, welche mit nur paraelektrischen oder nur ferroelektrischen Materialien nicht realisiert werden kann.

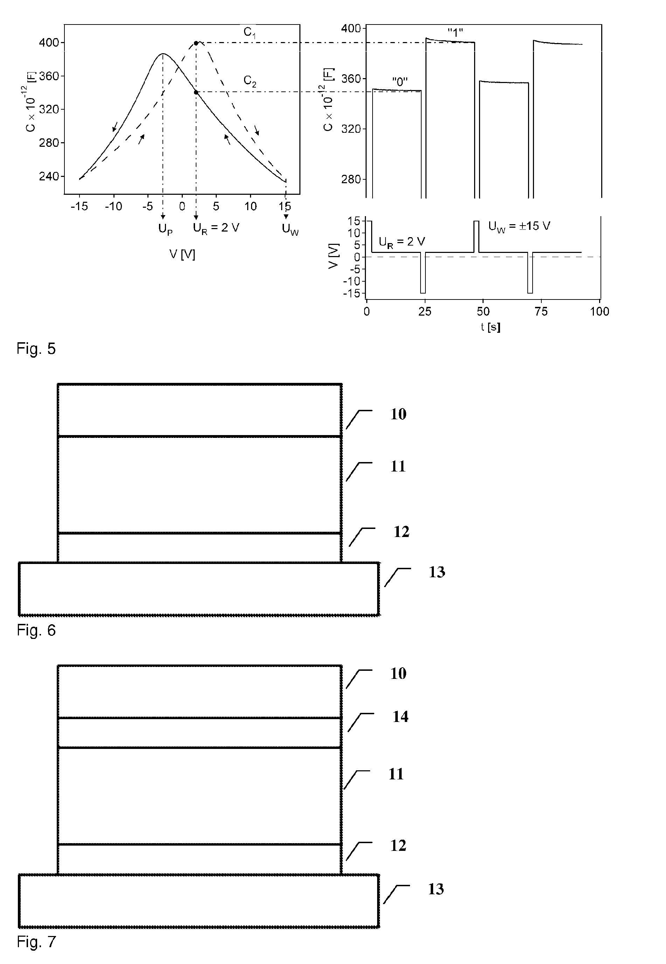

Bei dem bistabilen Kondensator handelt es sich um einen passiven (d.h. geringer Energieverbrauch), programmierbaren und nicht flüchtigen Speicher. Dies bedeutet, dass die zwei logischen Zustände, in diesem Fall die unterschiedlich großen Kapazitäten, die der Kondensator bietet, nach der Entfernung der zuvor angelegten elektrischen Spannung verbleiben (d. h. sie sind nicht flüchtig) und anschließend durch Anlegen einer Spannung umgeschaltet werden können (d. h. sie sind programmierbar). Durch eine kleine Lesespannung kann der Zustand ausgelesen werden und der Lesevorgang wird die gespeicherte Information nicht löschen. Ein typisches Schaltverhalten eines solchen Kondensators ist in Fig. 5 gezeigt. Hierbei wird das Schaltverhalten mit Hilfe der zeitabhängigen Kapazitätsmessung charakterisiert.

Die Erfindung wird nun anhand von Zeichnungen näher beschrieben:

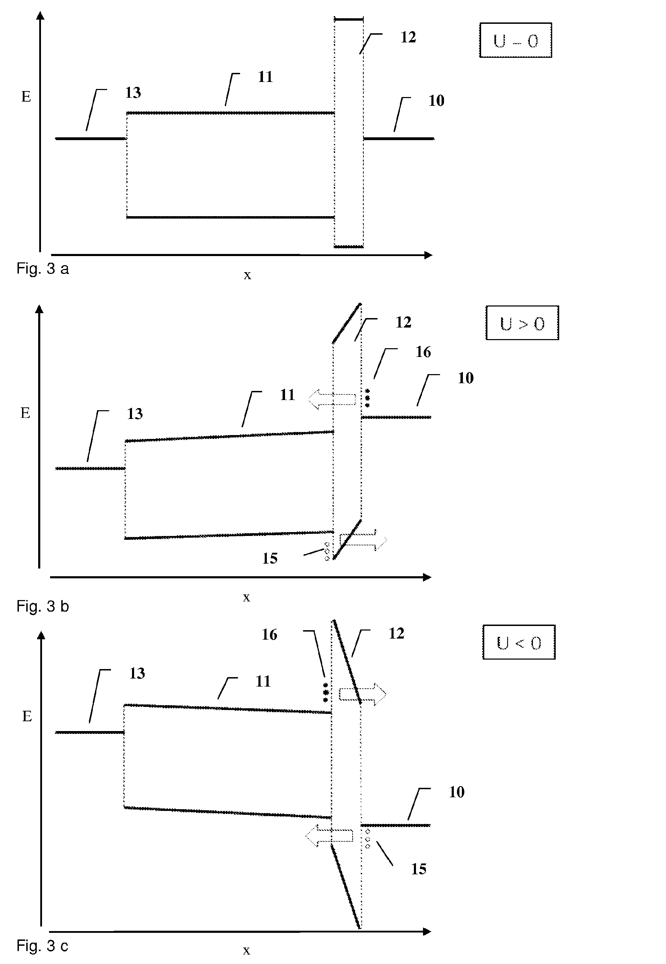

Fig. 2 zeigt einen ersten Schichtaufbau des erfindungsgemäßen Kondensators mit einem Schichtstapel bestehend aus einer ersten Elektrode 10, einer abstimmbaren Schicht 11, einer Barriereschicht 12 und einer zweiten Elektrode 13. Für die Elektroden 10 und 13 kann jedes leitende Material verwendet werden wie Metalle oder Halbleiter, beispielsweise Pt. Die abstimmbare Schicht 11 besteht aus Materialien mit einer hohen Permittivität (insbesondere > 100), die abhängig ist vom elektrischen Feld. Die Barriereschicht 12 besteht aus Materialien mit einer großen Energiebandlücke Eg (typischer Wert > 5 eV) und geringer Permittivität (< 50). Je größer der Unterschied der Permittivitäten zwischen der Barriereschicht 12 und der abstimmbaren Schicht 11 ist, umso besser ist dies für die Funktion des Kondensators. Der Faktor zwischen den beiden Permittivitäten sollte bevorzugt größer als 10 sein. Fig. 3 zeigt das Schema eines Energieband Diagrammes eines Varaktors und das Prinzip der Ladungsträgerinjektion. Die Barriereschicht 12 bildet eine hohe Trennschicht zwischen der abstimmbaren Schicht 11 und einer der Elektroden 10, 13. Wenn keine Spannung angelegt ist, ist das Bauelement in einem so genannten "flat-band situation" wie in Fig. 3 a dargestellt. Wenn eine Spannung auf das Bauelement angelegt wird, wird abhängig von der Polarität der Spannung das Ferminiveau der einen Elektrode 10 oder 13 erniedrigt in der andern Elektrode 13 oder 10 erhöht. Aufgrund der viel tieferen Permittivität der Barriereschicht 12 hat diese Schicht eine viel geringere Kapazität als die abstimmbare Schicht 11. Dadurch wird eine signifikante Spannung U auf die Sperrschicht 12 abfallen entsprechend der folgenden Gleichung:

$$U_{12} = \quad UC_{11}/(C_{11}+C_{12}), \qquad\qquad\qquad (1)$$

wobei $U_{12}$ die Spannung an der Barriereschicht 12 ist und $C_{11}$ und $C_{12}$ sind die Kapazitäten der abstimmbaren Schicht 11 und der Barriereschicht 12. Wenn an die erste Elektrode 10 wie in Fig. 3 b gezeigt eine negative Spannung angelegt wird, wird das Ferminiveau der ersten Elektrode 10 erhöht. Wenn die Spannung einen bestimmten Wert erreicht wird das Ferminiveau der ersten Elektrode 10 nahe an oder sogar über das Minimum des Ferminiveaus des Leitungsbandes der abstimmbaren Schicht 11 verschoben. Elektronen sind damit in der Lage in die dünne Barriereschicht 12 vorzudringen und einige Elektronen 16 werden in der Grenzfläche der abstimmbaren Schicht 11 und der Barriereschicht 12 nahe zum Leitungsband eingefangen. Dies gilt auch für Löcher 15 die durch die Barriereschicht 12 des Valenzbandes in die abstimmbare Schicht 11 zur oberen Elektrode 10 dringen. In diesem Fall ist die Grenzfläche der abstimmbaren Schicht 11 und der Barriereschicht 12 negativ geladen durch die eingefangenen Elektronen 16. Der umgekehrte Fall ist in Fig. 3 c dargestellt, wo an die erste Elektrode 10 eine positive Spannung angelegt ist. In diesem Fall sind die meisten der eingefangenen Elektronen 16 von der Grenzfläche entfernt und die Löcher 15 sind dort eingefangen, so dass der Grenzfläche positiv geladen ist.

Die Barriereschicht weist bevorzugt eine Dicke von 5-10 nm auf. Die besonders bevorzugte Struktur ist die Pt/BST/Al$_2$O$_3$/Pt.

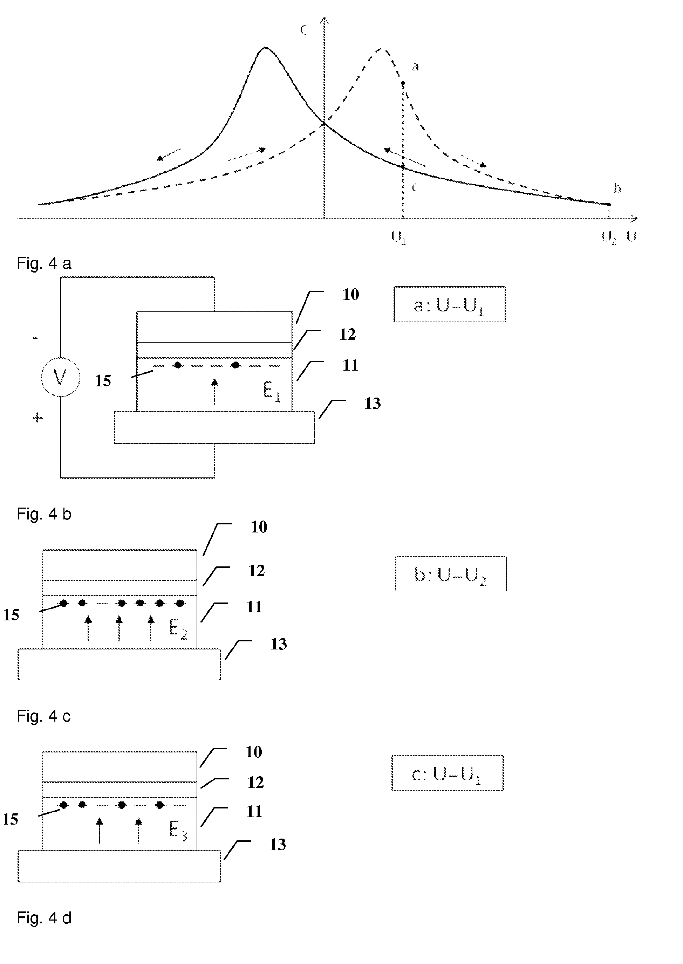

Fig. 4 zeigt das Prinzip der kapazitiven Spannungshysterese (capacitance-voltage (CV)) des Bauteils nach Fig. 2. Wenn eine geringe negative Spannung an der ersten Elektrode 10 angelegt wird (Fig. 4b), wird eine kleine Anzahl von Elektronen von der oberen Elektrode injiziert und durch die Barriereschicht 12 in der Grenzschicht eingefangen. Wenn eine höhere Spannung an der ersten Elektrode 10 angelegt wird (point b / Fig. 4c), werden viele Elektronen in der Grenzschicht nach der Barriereschicht 12 eingefangen. Wird die negative Spannung erniedrigt (Fig. 4 c), ist immer noch eine große Anzahl von Elektronen eingefangen solange die Polarität der Spannung sich nicht ändert. Auch wenn das gleiche externe elektrische Feld E (Spannung $U$/Dicke $d$) an das Bauteil angelegt wird in Fig. 4b und 4d werden im Fall von Fig. 4d mehr Elektronen eingefangen, welches das interne Feld in der abstimmbaren Schicht 11 erhöht $(E_3 > E_1)$. Dieses vergrößerte elektrische Feld führt zu einer Reduktion der Kapazität und bildet eine Hysterese. Wenn sich die Polarität der Spannung an der ersten Elektrode 10 ändert und diese eine positive Spannung erhält werden die meisten eingefangene Elektronen wieder von den Fallen in der Grenzschicht entfernt und Löcher werden injiziert und übernehmen den Platz der Elektronen. Die zwei gespiegelten CV-Kennlinien bilden dann eine symmetrische Hysterese.

Fig. 5 beschreibt die Lese-Schreib-Funktion der Bauteile nach Fig. 2. Der Betrieb des bistabilen Kondensators besteht aus einem Schreibvorgang und einem Lesevorgang, die zwei unterschiedlich großen Spannungen entsprechen. Für die Lese-Funktion wird eine Lesespannung $U_R$, welche zwischen 0 V und der Polarisationsspannung $U_P$ gewählt werden kann, am Bauteil angelegt und die zugehörige Kapazität $C_1$ oder $C_2$ kann ausgelesen werden, welche von der vorhergehenden CV Hysterese abhängig ist. Die Polarisationsspannung $U_P$ ist die Spannung, die benötigt wird um die Polarität der geladenen Grenzschicht zwischen der abstimmbaren Schicht 11 und der Barriereschicht 12 zu verändern. Bei der Polarisationsspannung $U_P$ ist das interne elektrische Feld kompensiert durch das externe elektrische Feld und dadurch erreicht die Kapazität des Bauelementes ihren maximalen Wert. Die Differenz zwischen $C_1$ oder $C_2$ verschwindet bei einer Spannung von 0 V und erreicht ein Maximum bei $U_P$. Im Prinzip kann die Lesespannung $U_R$ beliebig auf einen Wert zwischen 0 und $U_P$ gesetzt werden. Aber um einen grösseren Unterschied der Lesewerte zu erreichen wird ein $U_R$ nahe der Polarisationsspannung $U_P$ bevorzugt.

Für die Schreiboperation wird eine Schreibspannung $U_W$ angelegt. Die Schreibspannung $U_W$ muss grösser als die Spannung $U_P$ sein, bei der die Flachband-Situation (flat-band situation) und die maximale Kapazität in der abstimmbaren Schicht 11 erreicht wird, womit eine hinreichend hohe Ladungsträgerinjektion gestattet werden kann. Je grösser $U_W$ ist, desto grösser und stabiler ist die gespeicherte Ladung an der Grenzfläche. Dabei spielt wiederum die Feldstärke die entscheidende Rolle und eine Reduzierung der Schreibspannung $U_W$ ist durch die Reduzierung der Schichtdicke d der abstimmbaren Schicht 11 möglich, auch ohne auf die Stabilität der Ladung verzichten zu müssen.

Da die Hysterese symmetrisch ist, kann die Polarität von $U_W$ und $U_R$ beliebig korreliert werden. Fig. 5 zeigt den Fall bei dem beispielsweise eine positive Lesespannung von $U_R$ = 2 V gewählt wurde. Die Programmierung des Bauteils erfolgt mit einem kurzen Spannungspuls von $U_W$. Wenn z.B. eine Schreibspannung von 15V angelegt ist, befindet sich die CV-Kennlinie auf der unteren Kurve (durchgezogene Linie der Hysterese in Fig. 5) und der Kondensator weist bei z.B. 2V eine niedrige Kapazität auf, die als binär "0" definiert werden kann. Um den Zustand der Kapazität umzukehren wird entsprechend eine Schreibspannung von z.B. -15V angelegt. Der Kondensator weist dann bei z.B. 2V eine hohe Kapazität auf, die als binär "1" definiert werden kann. Die Definition der binären Zustände "0" und "1" ist auch umkehrbar und hängt von der Schaltung der endgültigen Vorrichtung ab.

Bei der zeitabhängigen Kapazitätsmessung in Fig. 5 (rechts) ist zu erkennen, dass die zwei Zustände der Kapazität nach der Entfernung von $U_W$ beim kontinuierlichen Auslesen erhalten bleiben und die Programmierung mehrmals wiederholt werden kann. Durch die anliegende Lesespannung ist eine leichte Abnahme, insbesondere bei der hohen Kapazität, zu sehen.

Für die Schreiboperation wird eine Schreibspannung $U_W$ angelegt, wobei diese Spannung größer sein muss als die Polarisationsspannung $U_P$. The Polarität der geladenen Grenzschicht wird verändert und die CV Hysterese verläuft entlang der durchgezogenen Linie in Fig. 5. In diesem Fall ist die logische "1" (oder "0"), welche mit der Kapazität $C_1$ korrespondiert, in dem Bauteil gespeichert, abhängig von der Schaltung. Um den gespeicherten Zustand zu löschen wird eine negative Spannung - $-U_W$ angelegt und die CV Hysterese läuft entlang der gestrichelten Linie in Fig. 5 zurück. In diesem Fall wird eine logische "0" (oder "1") in das Bauteil geschrieben, welche mit der größeren Kapazität $C_2$ korrespondiert.

Da die CV Hysterese des Bauteils symmetrisch ist, verlaufen die Lese-Schreib-Funktionen genauso, wenn die umgekehrten Betriebsspannungen verwendet werden. Die Verteilung des elektrischen Feldes in dem Schichtstapel kann mit folgender Gleichung ausgedrückt werden:

$$\varepsilon_{11}E_{11} + \sigma = \varepsilon_{12}E_{12} \qquad\qquad (2)$$

sowie

$$U = E_{11}d_{11} + E_{12}d_{12} \qquad\qquad (3)$$

wobei $\sigma$ die Flächendichte der gespeicherten Ladung an der Grenzfläche von der abstimmbaren Schicht 11 und der Barriereschicht 12 ist. $\varepsilon_{11}$ und $\varepsilon_{12}$ sind die Permittivitäten der abstimmbaren Schicht 11 bzw. der Barriereschicht 12. $E_{11}$ und $E_{12}$ sind die elektrische Feldstärken in der abstimmbaren Schicht 11 bzw. der Barriereschicht 12. $U$ ist die gesamte angelegte Spannung. $d_{11}$ und $d_{12}$ sind die Dicke der abstimmbaren Schicht 11 bzw. der Barriereschicht 12.

Durch obige Gleichungen ergibt sich die Feldstärke in der jeweiligen Schicht wie folgt

$$E_{11} = (U - d_{12}\,\sigma/\varepsilon_{12})/(d_{11} + d_{12}\varepsilon_{11}/\varepsilon_{12}) \qquad\qquad (4)$$

$$E_{12} = (\varepsilon_{11}E_{11} + \sigma)/\varepsilon_{12} \qquad\qquad (5)$$

Die Größe der Hysterese hängt von der Polarisationsspannung $U_P$ ab, bei der das elektrische Feld in der abstimmbaren Schicht 11 gleich null ist ($E_{11}=0$). Daraus ergibt sich

$$U_P = d_{12}\sigma/\varepsilon_{12} \qquad\qquad (6)$$

Wobei die Polarisationsspannung $U=U_P$ der Spannung entspricht, bei der die maximale Kapazität auftritt. Die maximal auftretende Kapazität hängt stark von der Dicke der Barriereschicht 12 ($d_{12}$) ab. Das heißt, wenn die abstimmbare Schicht 11 die gleiche Dicke hat, fällt umso mehr Spannung an die Barriereschicht 12 ab umso dicker die Barriereschicht 12 ist. Die Spannung, die an der abstimmbaren Schicht 11 abfällt ist geringer. Dies erfordert eine höhere Polarisationsspannung $U_P$ um das interne elektrische Feld in der abstimmbaren Schicht 11 zu kompensieren, welche durch die geladene Grenzschicht generiert wurde um die Flachband-Situation (flat-band situation) zu erreichen. Dies ermöglicht es die Größe der CV Hysterese-Schleife durch Veränderung der Dicke der Barriereschicht 12 zu verändern.

Fig. 6 zeigt eine zweite Struktur der Erfindung. Diese Struktur hat das gleiche Funktionsprinzip wie die erste Struktur, die in Fig. 2 gezeigt ist, außer das sich die Barriereschicht 12 zwischen der abstimmbaren Schicht 11 und der zweiten Elektrode 13 befindet.

Fig. 7 zeigt eine dritte Struktur der Erfindung. Diese Struktur besteht aus einer abstimmbaren Schicht 11, welche zwischen zwei Barriereschichten 12, 14 angeordnet ist und zwei Elektroden 10 und 13. Im Vergleich mit der ersten Struktur, gezeigt in Fig. 2, hat dieser Aufbau sowohl das gleiche Prinzip für die Ladungsinjektion und Formation der CV Hysterese als auch für die Lese- und Schreib-Funktion. Diese Struktur besitzt zwei Grenzschichten zwischen der abstimmbaren Schicht 11 und den Barriereschichten 12, 14, welche die Dichte der Fallen für die injizierten Ladungen und damit das interne elektrische Feld in der abstimmbaren Schicht 11 bestimmen. Als Ergebnis kann die kapazitive Differenz zwischen den zwei logischen Zuständen C1 und C2 wie in Fig. 5 gezeigt erhöht werden.

Basierend auf den bistabilen Kondensatoren können passive programmierbare Hochfrequenz-Bauteile zur Radiofrequenz-Identifizierung (engl. radio frequency identification, Abk. RFID) realisiert werden. Hierzu werden zwei exemplarische Schaltungen und die entsprechenden Funktionsprinzipien vorgestellt.

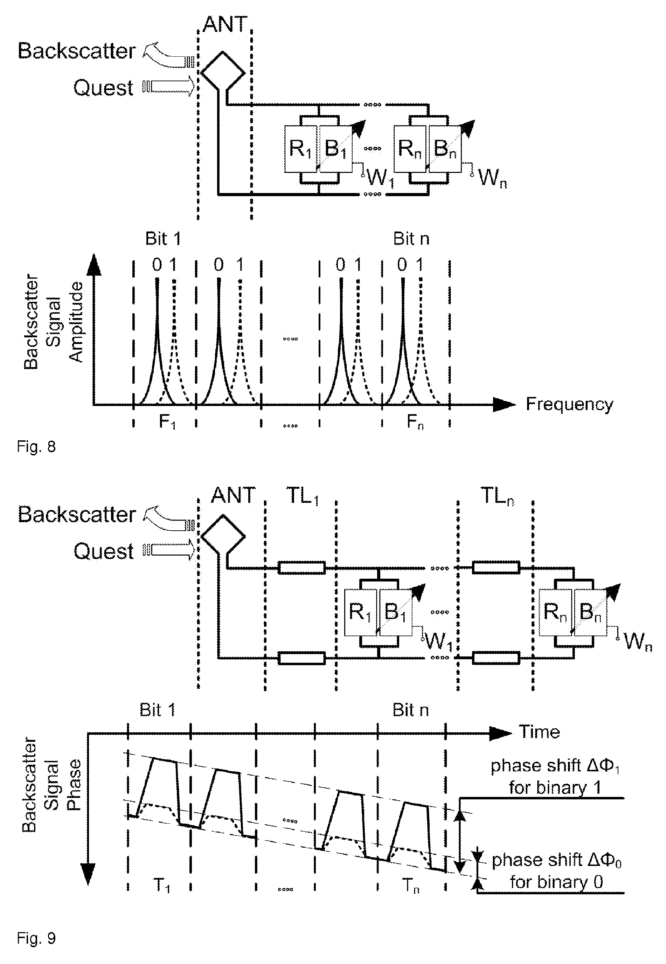

Wie in Fig. 8 dargestellt, besteht die erste Schaltung aus bistabilen Kondensatoren $B_1$ bis $B_n$ und Mikrowellenresonatoren $R_1$ bis $R_n$, verbunden mit einer Antenne (ANT) am Eingang. Jeder Resonator arbeitet bei einer einzelnen Frequenz. Die Kodierung der ersten Schaltung erfolgt in einer Frequenzdomäne.

Wenn die Schaltung durch das externe Lesegerät bei Hochfrequenz in einer Bandbreite zwischen den Frequenzen $f_1$ und $f_n$ angefragt wird, streuen die Resonatoren das Signal in ihre einzelnen Frequenzen zurück, wie die Peaks in durchgezogenen Linien in Fig. 8 zeigen. Diese rückgestreuten Signale werden dann extern detektiert. Die einzelnen Frequenzen $f_1$ und $f_n$ stellen die ID-Codes von Bit 1 bis Bit n des RFID-Tags dar. Wenn die bistabilen Kondensatoren $B_1$ bis $B_n$ durch die Schreib-Schnittstellen (engl. word lines) $W_1$ bis $W_n$ geschrieben werden, werden die Kapazitäten zwischen den zwei Zuständen geschaltet. Da die Resonatoren parallel miteinander verbunden sind, führen die Kapazitäten der Kondensatoren zu einem Spektrum mit einzelnen Verschiebungen der Resonanzfrequenzen, wie die Peaks in gestrichelten Linien zeigen. Wenn die Kondensatoren unterschiedlich eingestellt sind, stellen die spektralen Lagen der Resonanzfrequenzen eine Folge von binären Zuständen "0" und "1" dar und der RFID-Tag wird dadurch programmiert.

Wie in Fig. 9 dargestellt, werden in der zweiten Schaltung Übertragungsleitungen $TL_1$ bis $TL_n$ zwischen den Kondensator-geladenen Resonatoren eingeführt. Die Kodierung dieser Schaltung arbeitet im Zeitbereich. Die Schaltung wird auf einer einzigen Frequenz f vom externen Lesegerät angefragt und die rückgestreuten Signale werden in der zeitlichen Abfolge gemessen. Wenn ein Impuls bei der Frequenz f von der Antenne empfangen wird, breitet er sich durch $TL_1$ bis $TL_n$ fortlaufend aus. Zugleich streut der Impuls bei jedem Kondensator-geladenen Resonator je nach seiner Impedanz zurück. Wie die durchgezogenen Linien im Kodierungsschema in Fig. 9 zeigen, werden die Rückstreuungen der Impulse zu unterschiedlichen Zeitpunkten $t_1$ bis $t_n$ empfangen, welche die ID-Codes Bit 1 bis Bit n darstellen. Wenn die Kondensatoren $B_1$ bis $B_n$ durch die Schreib-Schnittstellen $W_1$ bis $W_n$ geschrieben werden, werden die Kapazitäten zwischen den zwei Zuständen geschaltet. Bei der Frequenz f verändert sich an jedem Resonator die Phasenverschiebung der reflektierten Impulse durch die veränderte Kapazität, wie die gestrichelten Linien zeigen. Wenn die Kondensatoren unterschiedlich eingestellt sind, stellen in diesem Fall statt Resonanzfrequenzen die Phasenverschiebungen eine Folge von binären Zuständen "0" und "1" dar und der RFID-Tag ist dadurch programmiert.

**Bezugszeichenliste**

10    erste Elektrode

11  abstimmbare Schicht

12  erste Barriereschicht

13  zweite Elektrode

14  zweite Barriereschicht

15  Elektronen

16  Löcher

Zeichnungen:

Fig. 1 zeigt die Anhängigkeit der induzierten Polarisation und der relative Permittivität vom elektrischen Feld für paraelektrisches und ferroelektrisches Material

Fig. 2 zeigt ein erstes Ausführungsbeispiel mit einem ersten Schichtaufbau der Erfindung

Fig. 3 zeigt ein schematisches Energiebanddiagramm zur ersten Struktur nach Fig. 2 unter Flachband Situation, in Sperr- und Durchlassrichtung. Diese Kurve zeigt die prinzipielle Ladungsinjektion an der Grenzschicht der Elektrode 10 und der abstimmbaren Schicht 12. Punkte und Kreise zeigen Elektronen 15 bzw. Löcher 16.

Fig. 4 zeigt die Formation der kapazitiven Spannungshysterese durch die Ladungsträgerinjektion und eingefangene Ladungen an der Grenzschicht zur abstimmbaren Schicht 11 und zur Barriereschicht 12, entsprechend der ersten Struktur wie in Fig. 2 gezeigt.

Fig. 5 zeigt das Prinzip der Lese-/Schreib-Funktion.

Fig. 6 zeigt ein zweites Ausführungsbeispiel.

Fig. 7 zeigt ein drittes Ausführungsbeispiel.

Fig. 8 zeigt eine exemplarische Schaltung und das Kodierungsschema für die Anwendungen der bistabilen BST-Kondensatoren als RFID-Tags in der Frequenzdomäne. $R_n$, $B_n$ und $W_n$ deuten die Widerstände, bistabile Kondensatoren und Schreib-Schnittstellen (engl. word lines) an.

Fig. 9 zeigt eine exemplarische Schaltung und das Kodierungsschema für die Anwendungen der bistabilen BST-Kondensatoren als RFID-Tags in der Zeitdomäne. $R_n$, $B_n$ und $W_n$ deuten die Widerstände, bistabile Kondensatoren und Schreib-Schnittstellen (engl. word lines) an.

Abkürzungen:

P       Polarisation

$\varepsilon_r$     relative Permittivität (oder Dielektrizitätskonstante)

E       elektrische Feldstärke

U       elektrische Spannung

$U_R$     Lesespannung

Uw      Schreibspannung

$U_P$     Polarisationsspannung

σ       Flächendichte der Ladung

d       Dicke

$R_n$      Widerstände

$B_n$      bistabilen Kondensatoren

$W_n$     Schreib-Schnittstellen

$TL_n$     Übertragungsleitungen

**Patentansprüche**

1.  Ein Kondensator, **dadurch gekennzeichnet dass** der Kondensator mindestens eine Schicht eines Materials mit einer hohen abstimmbaren relativen Permittivität (abstimmbare Schicht (11)) und mindestens einer zweiten Schicht eines Materials mit einer großen Energiebandlücke (Barriereschicht (12)) aufweist welche beide zwischen den Elektroden (10, 13) des Kondensators angeordnet sind.

2.  Ein Kondensator nach Anspruch 1, **dadurch gekennzeichnet dass** die abstimmbare Schicht (11) ein Material mit einer nicht-linearen relativen Permittivität aufweist.

3.  Ein Kondensator nach einem der Ansprüche 1 und 2 **dadurch gekennzeichnet dass** die abstimmbare Schicht (11) eines der folgenden Materialien aufweist oder eine Kombination aus den folgenden Materialien: $BaTiO_3$, $SrTiO$, $(Ba,Sr)TiO_3$, $(Ba,Ca)TiO_3$, $Ba(Ti,Zr)O_3$, $Ba(Ti,Sn)O_3$ und weiteren Materialien mit nicht linearer relativer Permittivität.

4.  Ein Kondensator nach einem der Ansprüche 1 bis 3 **dadurch gekennzeichnet dass** die Barriereschicht (12) eines der folgenden Materialien aufweist: $SiO_2$, $Si_3N_4$, $Al_2O_3$, $ZrO_2$, $ZrSiO_4$, $HfO_2$, $HfSiO_4$, $La_2O_3$, $Y_2O_3$, $MgO$, $CaO$, $SrO$.

5.  Ein Kondensator nach einem der Ansprüche 1 bis 4 **dadurch gekennzeichnet, dass** der Kondensator folgenden Schichtaufbau aufweist:

    I. Eine erste Elektrode (10)
    II. Eine abstimmbare Schicht (11) mit einer hohen relativen Permittivität, die durch ein elektrisches Feld abgestimmt werden kann
    III. Eine Barriereschicht (12) auf der abstimmbaren Schicht (11), mit einer relative Permittivität, die niedriger ist als die relative Permittivität der abstimmbaren Schicht (11)
    IV. Eine zweite Elektrode (13) auf der Barriereschicht (12)

6.  Ein Kondensator nach einem der Ansprüche 1 bis 4 **dadurch gekennzeichnet, dass** der Kondensator folgenden Schichtaufbau aufweist:

    I. Eine erste Elektrode (10)
    II. Eine Barrierschicht (12)
    III. Eine abstimmbare Schicht (11) mit einer relativen Permittivität, die größer ist als die der Barriereschicht (12) und durch ein elektrisches Feld abstimmbar ist
    IV. Eine zweite Elektrode (13) auf der abstimmbaren Schicht (11)

7.  Ein Kondensator nach einem der Ansprüche 1 bis 4 **dadurch gekennzeichnet, dass** der Kondensator folgenden Schichtaufbau aufweist:

    I. Eine erste Elektrode (10)
    II. Eine Barriereschicht (12) mit einer ersten relativen Permittivität
    III. Eine abstimmbare Schicht (11) mit einer zweiten relativen Permittivität, die größer ist als die der Barriereschicht (12) und durch ein elektrisches Feld abstimmbar ist
    IV. Eine weitere Barriereschicht (14) mit einer dritten relativen Permittivität die geringer ist als die zweite relative Permittivität der abstimmbaren Schicht (11)
    V. Eine zweite Elektrode (13) auf der Barriereschicht (14)

8.  Eine Speichervorrichtung **dadurch gekennzeichnet, dass** diese mindestens einen Kondensator nach einem der Ansprüche 1 bis 7 aufweist.

9.  Ein Varaktor **dadurch gekennzeichnet, dass** dieser mindestens einen Kondensator nach einem der Ansprüche 1 bis 7 aufweist.

10. Ein programmierbarer passiver RFID-Tag mit Codierung im Frequenzbereich, aufweisend eine Antenne, mindestens einen Mikrowellen-Resonator und mindestens einen Kondensator nach einem der Ansprüche 1 bis 9.

11. Ein programmierbarer passiver RFID-Tag mit Codierung im Zeitbereich, aufweisend eine Antenne, mindestens einen Mikrowellen-Resonator und mindestens einen Kondensator nach einem der Ansprüche 1 bis 9.

Fig. 1 a

Fig. 1 b

Fig. 1 c

Fig. 1 d

10

12

11

13

Fig. 2

Fig. 3 a

Fig. 3 b

Fig. 3 c

Fig. 4 a

a: U ~ U₁

Fig. 4 b

b: U ~ U₂

Fig. 4 c

c: U ~ U₁

Fig. 4 d

Fig. 5

Fig. 6

Fig. 7

Fig. 8

Fig. 9

Europäisches
Patentamt

European
Patent Office

Office européen
des brevets

**EUROPÄISCHER RECHERCHENBERICHT**

Nummer der Anmeldung

EP 11 17 0576

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 2004/233610 A1 (BASCERI CEM [US] ET AL) 25. November 2004 (2004-11-25) * Abbildungen 1,2 * * Absätze [0002], [0004], [0027], [0040], [0045], [0053] - [0054] * * Ansprüche 21,24,35 * ----- | 1-11 | INV. H01G4/12 H01G7/06 H01L21/02 |
| X | US 2006/084225 A1 (PARK IN-SUNG [KR] ET AL) 20. April 2006 (2006-04-20) * Absatz [0007] - Absatz [0011] * ----- | 1-11 | |
| X | WO 2010/023575 A1 (NXP BV [NL]; FURUKAWA YUKIKO [NL]; KOCHUPURACKAL JINESH BALAKRISHNA PI) 4. März 2010 (2010-03-04) * Seite 6, Zeile 29 - Seite 7, Zeile 16 * * Seite 9, Zeile 6 - Zeile 33; Abbildungen 2,3 * ----- | 1-11 | |
| X | US 2010/309607 A1 (LIU SHUR-FEN [TW] ET AL) 9. Dezember 2010 (2010-12-09) * Absatz [0023] - Absatz [0029] * ----- | 1-11 | RECHERCHIERTE SACHGEBIETE (IPC) |
| A | US 2004/206995 A1 (ARISUMI OSAMU [JP] ET AL) 21. Oktober 2004 (2004-10-21) * Absatz [0007]; Abbildungen 1,2 * * Absatz [0032] - Absatz [0040] * ----- | 1-11 | H01G H01L |
| A | WO 2005/020257 A2 (POLYIC GMBH & CO KG [DE]; CLEMENS WOLFGANG [DE]; ZIPPERER DIETMAR [DE]) 3. März 2005 (2005-03-03) * Abbildungen 1,3 * * Seite 1, Zeile 18 - Zeile 23 * * Seite 18, Zeile 7 - Zeile 10 * * Seite 6, Zeile 6 - Seite 9, Zeile 32 * ----- | 1-11 | |

Der vorliegende Recherchenbericht wurde für alle Patentansprüche erstellt

| Recherchenort | Abschlußdatum der Recherche | Prüfer |
|---|---|---|
| München | 15. November 2011 | Sedlmaier, Stefan |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

................................................................

& : Mitglied der gleichen Patentfamilie, übereinstimmendes Dokument

EPO FORM 1503 03.82 (P04C03)

**ANHANG ZUM EUROPÄISCHEN RECHERCHENBERICHT**
**ÜBER DIE EUROPÄISCHE PATENTANMELDUNG NR.**

EP 11 17 0576

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

15-11-2011

| Im Recherchenbericht angeführtes Patentdokument | Datum der Veröffentlichung | Mitglied(er) der Patentfamilie | Datum der Veröffentlichung |
|---|---|---|---|
| US 2004233610 A1 | 25-11-2004 | US 2004233610 A1<br>US 2004235242 A1<br>US 2006274477 A1 | 25-11-2004<br>25-11-2004<br>07-12-2006 |
| US 2006084225 A1 | 20-04-2006 | KR 20040070481 A<br>US 2004166628 A1<br>US 2006084225 A1 | 11-08-2004<br>26-08-2004<br>20-04-2006 |
| WO 2010023575 A1 | 04-03-2010 | CN 102132367 A<br>EP 2319060 A1<br>US 2011147891 A1<br>WO 2010023575 A1 | 20-07-2011<br>11-05-2011<br>23-06-2011<br>04-03-2010 |
| US 2010309607 A1 | 09-12-2010 | KEINE | |
| US 2004206995 A1 | 21-10-2004 | CN 1550043 A<br>EP 1516355 A2<br>TW I229891 B<br>US 2004206995 A1<br>US 2005245023 A1<br>WO 03100824 A2 | 24-11-2004<br>23-03-2005<br>21-03-2005<br>21-10-2004<br>03-11-2005<br>04-12-2003 |
| WO 2005020257 A2 | 03-03-2005 | CN 1871675 A<br>DE 10338277 A1<br>EP 1656683 A2<br>ES 2297453 T3<br>US 2007030623 A1<br>WO 2005020257 A2 | 29-11-2006<br>17-03-2005<br>17-05-2006<br>01-05-2008<br>08-02-2007<br>03-03-2005 |

EPO FORM P0461

Für nähere Einzelheiten zu diesem Anhang : siehe Amtsblatt des Europäischen Patentamts, Nr.12/82